Europäisches Patentamt

European Patent Office

Office européen des brevets

(19)

(11) EP 0 905 523 B1

(12) EUROPÄISCHE PATENTSCHRIFT

(45) Veröffentlichungstag und Bekanntmachung des Hinweises auf die Patenterteilung:
**10.11.2004 Patentblatt 2004/46**

(51) Int Cl.⁷: $G01R\ 33/09$

(21) Anmeldenummer: **98117332.1**

(22) Anmeldetag: **12.09.1998**

(54) **Sensoreinrichtung zur Richtungserfassung eines äu eren Magnetfeldes mittels eines magnetoresistiven Sensorelementes**

Sensor for direction measurement of an external magnetic field with a magnetoresistive element

Capteur pour mesurer la direction d'un champ magnétique extern au moyen d'un élément magnétorésistif

(84) Benannte Vertragsstaaten:
**DE ES FR GB IT**

(30) Priorität: **24.09.1997 DE 19742134**

(43) Veröffentlichungstag der Anmeldung:
**31.03.1999 Patentblatt 1999/13**

(73) Patentinhaber: **Infineon Technologies AG**
**81669 München (DE)**

(72) Erfinder: **van den Berg, Hugo Dr.**
**91074 Herzogenaurach (DE)**

(74) Vertreter:
**Müller, Wolfram Hubertus, Dipl.-Phys. et al**
**Patentanwälte**
**Maikowski & Ninnemann,**
**Postfach 15 09 20**
**10671 Berlin (DE)**

(56) Entgegenhaltungen:
**EP-A- 0 710 850**       **DE-A- 3 317 594**
**DE-A- 4 317 512**       **DE-A- 19 649 265**
**DE-C- 19 532 674**

**Beschreibung**

Die Erfindung bezieht sich auf eine Sensoreinrichtung zur Erfassung der Richtung eines äußeren Magnetfeldes mittels wenigstens eines Sensorelementes, das ein einen sehr großen magnetoresistiven Effekt (GMR) zeigendes Mehrschichtensystem aufweist, welches

- mindestens eine weichmagnetische Meßschicht,
- mindestens eine vergleichsweise härtere Biasschicht mit vorgegebener Magnetisierungsrichtung sowie
- mindestens eine dazwischen angeordnete, nicht-magnetische Zwischenschicht

enthält. Eine entsprechende Sensoreinrichtung ist der WO 94/17426 zu entnehmen. In der WO 94/17426 wird außerdem eine Anordnung von zwei MR-Sensoren mit senkrecht zueinander gerichteten Berugsachsen offenbart.

Aus der EP 0 710 850 A2 ist ein Magnetfeldsensor bekannt, bei dem vier Magnetfeldsensorbereiche in einer Brückenschaltung miteinander verbunden sind. Die Vorzugsmagnetisierungsachsen der jeweiligen Magnetfeldsensoren liegen parallel zueinander.

Aus der DE 195 32 674 C1 ist ein Drehwinkelgeber unter Verwendung von Giant-Magnetowiderstandsmaterialien bekannt. In einer auf einem Substrat aufgebrachten, kreisförmigen und weichmagnetischen Schicht sind Kanäle eingebracht, in denen jeweils ein Giant-Magnetowiderstandsmaterial in Streifenform eingebracht ist.

In Schichten aus ferromagnetischen Übergangsmetallen wie Ni, Fe oder Co und deren Legierungen kann eine Abhängigkeit des elektrischen Widerstandes von der Größe und der Richtung eines das Material durchdringenden Magnetfeldes gegeben sein. Den bei solchen Schichten auftretenden Effekt nennt man "anisotropen Magnetowiderstand (AMR)" oder "aniosotropen magnetoresistiven Effekt". Er beruht physikalisch auf den unterschiedlichen Streuquerschnitten von Elektronen mit verschiedenem Spin und der Spinpolarität des D-Bandes. Die Elektronen werden als Majoritäts- bzw. Minoritäts-Elektronen bezeichnet. Für entsprechende magnetoresistive Sensoren wird im allgemeinen eine dünne Schicht aus einem solchen magnetorisistiven Material mit einer Magnetisierung in der Schichtebene vorgesehen. Die Widerstandsänderung bei Drehung der Magnetisierung bezüglich der Richtung eines über den Sensor geleiteten Stromes kann dann einige Prozent des normalen isotropen (= ohm'schen) Widerstandes betragen.

Ferner sind magnetoresistive Mehrschichtensysteme bekannt, welche mehrere, zu einem Stapel angeordnete ferromagnetische Schichten enthalten, die jeweils durch metallische, nicht-magnetische Zwischenschichten voneinander getrennt sind und deren Magnetisierungen jeweils vorzugsweise in der Schichtebene liegen. Die Dicken der einzelnen Schichten sind dabei deutlich geringer als die mittlere freie Weglänge der Leitungselektronen gewählt. In derartigen Mehrschichtensystemen kann nun zusätzlich zu dem erwähnten anisotropen magnetoresistiven Effekt AMR ein sogenannter giant-magnetoresistiver Effekt" oder Giant-Magnetowiderstand (GMR)" auftreten (vgl. z.B. EP 0 483 373 A). Ein solcher GMR-Effekt beruht auf der unterschiedlich starken Streuung von Majoritäts- und Minoritäts-Leitungselektronen an den Grenzflächen zwischen den ferromagnetischen Schichten und den dazu benachbarten Zwischenschichten sowie auf Streueffekten innerhalb dieser Schichten. Der GMR-Effekt ist dabei ein isotroper Effekt. Er kann erheblich größer sein als der anisotrope Effekt AMR. Im allgemeinen spricht man von einem GMR-Effekt (bei Raumtemperatur), wenn er Werte annimmt, die deutlich über denen von AMR-Einschichtelementen liegen.

Bei einem ersten Typ von entsprechenden, einem GMR-Effekt zeigenden Mehrschichtensystemen sind benachbarte magnetische Schichten ohne ein äußeres Magnetfeld aufgrund einer gegenseitigen Kopplung magnetisch antiparallel ausgerichtet. Diese Ausrichtung kann durch ein äußeres Magnetfeld in eine parallele Ausrichtung überführt werden. Demgegenüber weist ein zweiter Typ von GMR-Mehrschichtensystemen eine sogenannte Biasschicht auf, die magnetisch härter ist als eine vorhandene magnetisch möglichst weiche Meßschicht. Die Meßschicht und / oder die Biasschicht können dabei auch jeweils durch mehrere zu einem Paket gestapelte Schichten ersetzt sein. Nachfolgend sei jedoch nur von jeweils einzelnen Schichten ausgegangen.

Die Meßschicht und die Biasschicht sind bei einem derartigen Schichtensystem vom zweiten Typ durch eine nicht-magnetische Zwischenschicht gegenseitig magnetisch entkoppelt. Ohne ein äußeres Magnetfeld stehen dann die Magnetisierungen der beiden magnetischen Schichten irgendwie zueinander, beispielsweise antiparallel. Unter dem Einfluß eines äußeren Magnetfeldes $H_m$ (= Meßfeldkomponente in der Schichtebene der Meßschicht) wird dann die Magnetisierung $M_m$ der weichmagnetischen Meßschicht entsprechend der Richtung des Magnetfeldes ausgerichtet, während die Ausrichtung der magnetisch härteren Biasschicht praktisch unverändert bleibt. Dabei bestimmt der Winkel $\phi$ zwischen den Magnetisierungsrichtungen der beiden Schichten den Widerstand des Mehrschichtensystems: Bei einer parallelen Ausrichtung ist der Widerstand klein und bei einer antiparallelen groß. Dies folgt aus der Tatsache, daß eine eindeutige Beziehung zwischen den Größen $M_m$ und $H_m$ gegeben ist. Im einfachsten Fall gilt dabei

$$M_m \bullet H_m = M_m H_m.$$

(Dabei sind die vektoriellen Größen durch fette Schreibweise und die skalaren Größen durch magere Schreibweisen gekennzeichnet).

Das Magnetowiderstandssignal ΔR eines derartigen GMR-Mehrschichtensystems ist dann gegeben durch

$$\Delta R = \Delta(1-\cos\phi).$$

Aus dieser Gleichung ist ersichtlich, dass ΔR für $\phi = \phi_0$ und $\phi = -\phi_0$ die gleichen Werte annimmt. Dies bedeutet aber, dass der Winkel $\phi$ nur in einem Sektor von 180° eindeutig erfasst werden kann. Darüber hinaus ist die Winkelempfindlichkeit $d\Delta R/d\theta = \Delta\sin\theta$ für $\theta = 0$ und $\theta = \pi$ sehr gering, wobei $\theta$ der Winkel zwischen der Richtung des äußeren Magnetfelds $\mathbf{H_m}$ und der durch die Magnetisierung der Biasschicht festgelegten Bezugsrichtung ist (vgl. die eingangs genannte WO-Schrift).

Aufgabe der vorliegenden Erfindung ist es deshalb, die Sensoreinrichtung mit den eingangs genannten Merkmalen dahingehend auszugestalten, dass mit ihr eine 360°-Winkeldetektion ermöglicht ist und das Problem einer zu niedrigen Empfindlichkeit vermindert ist.

Diese Aufgabe wird erfindungsgemäß dadurch gelöst, dass das wenigstens eine Sensorelement mindestens zwei Elementteile enthält, deren Mehrschichtensysteme auf einem gemeinsamen Substrat in dünnen Schichten aufgebracht sind, wobei deren Magnetisierungsrichtungen mit einem eingeschlossenen Winkel von ≠ 0° oder 180° eingeprägt werden und deren Meßsignale gemeinsam auszuwerten sind.

Der Erfindung liegt dabei die Überlegung zugrunde, dass mit den beiden vorzugsweise gleich aufgebauten Sensorelementteilen zwei gemeinsam zu betrachtende bzw. auszuwertende Sensorteilsignale zu gewinnen sind, die eine eindeutige Unterscheidungsmöglichkeit zwischen den Bereichen 0° bis 180° und 180° bis 360° schaffen.

Vorteilhafte Ausgestaltungen der erfindungsgemäßen Sensoreinrichtung gehen aus den Unteransprüchen hervor.

Die Erfindung wird nachfolgend anhand der Zeichnung noch weiter erläutert. Dabei zeigen jeweils schematisch die

Figur 1 einen Querschnitt durch einen einzelnen Sensorelementteil einer erfindungsgemäßen Sensoreinrichtung,

Figur 2 eine Aufsicht auf zwei Sensorelementteile mit komplementären Meßbereichen und deren zugehörende Meßsignalkurven,

Figur 3 eine Aufsicht auf eine besondere Ausführungsform eines Sensorelementteiles, sowie

Figur 4 eine Aufsicht auf eine Leitergeometrie zur Magnetisierung von Sensorelementteilen gemäß Figur 3.

In den Figuren sind sich entsprechende Teile jeweils mit denselben Bezugszeichen versehen.

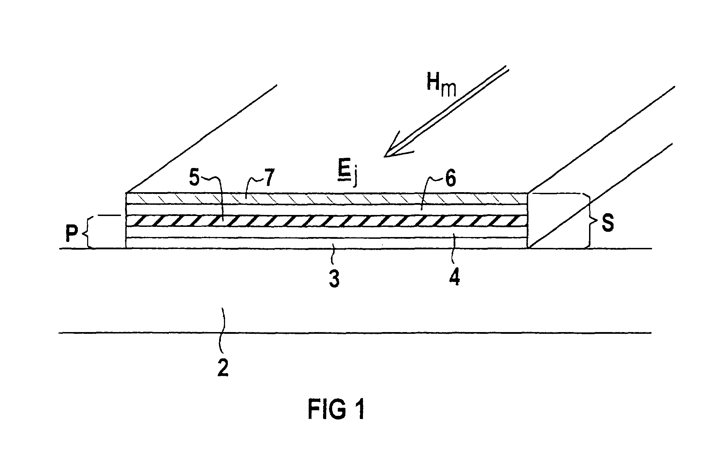

Eine erfindungsgemäße Sensoreinrichtung enthält mindestens ein Sensorelement, das wenigstens zwei Elementteile umfaßt, die auf einem gemeinsamen Substrat in Dünnfilmtechnik erstellt sind. Der Aufbau dieser Elementteile ist an sich bekannt (vgl. z.B. EP 0 483 373 A oder die DE-A-Schriften 42 32 244, 42 43 357 oder 42 43 358). Gemäß Figur 1 enthält jeder Elementteil $E_j$ ein auf einem Substrat 2 aufgebrachtes, für ein GMR-Element typisches Mehrschichtensystem S. Dieses Mehrschichtensystem besitzt vorteilhaft als unterste Schicht eine hartmagnetische Schicht 3, eine darauf aufgebrachte, als Koppelschicht wirkende Zwischenschicht 4 sowie eine auf dieser abgeschiedene ferro- oder ferrimagnetische Schicht 5. Diese Schicht 5 stellt dabei eine Biasschicht mit im Meßbereich zumindest annähernd konstanter Magnetisierungsrichtung in ihrer Schichtebene dar. Die insbesondere antiferromagnetisch gekoppelten Schichten 3 bis 5 bilden ein sogenanntes Biasschichtpaket P. Statt dieses Paketes kann auch ein magnetisch verhältnismäßig hartes Subsystem aus einer ferromagnetischen Schicht und einer unmittelbar anliegenden, antiferromagnetischen Schicht oder nur eine einzelne Biasschicht vorgesehen sein. Gemäß dem angenommenen Ausführungsbeispiel ist das Schichtpaket von einer magnetfeldempfindlichen, magnetisch möglichst weichen Meßschicht 7 über eine nicht-magnetische Zwischenschicht 6 magnetisch wenigstens annähernd entkoppelt. An der Meßschicht sind in der Figur nicht dargestellte Anschlußkontakte zum Führen eines vorgesehenen Stromes über den Elementteil angebracht. Dieser Aufbau des Schichtensystems S kann noch mit einer Schutzschicht überzogen sein. Das zumindest hinsichtlich seiner Richtung zu detektierende (äußere) magnetische Meßfeld $\mathbf{H_m}$ ist durch eine gepfeilte Linie angedeutet.

Der Widerstand eines solchen GMR-Sensorelementteils $E_j$ hängt dann von der relativen Orientierung der Magnetisierung der Meßschicht 7 gegenüber der des Biasschichtpakets P ab. Die Änderung dieses Widerstandes läßt sich ausnutzen, um die Richtung eines angelegten Magnetfeldes und so z.B. Drehpositionen oder absolute Positionen zu bestimmen (vgl. auch WO 94/17426). Diese Widerstandsänderung legt die Größe $\Delta R_r$ des magnetoresistiven Effektes fest. Die Größe $\Delta R_r$ ist dabei folgendermaßen definiert:

$$\Delta R_r = [R(\uparrow\downarrow) - R(\uparrow\uparrow)]/R(\uparrow\uparrow).$$

Wegen der Feldrichtungsempfindlichkeit der GMR-Sensorelemente stellt der magnetoresistive Effekt $\Delta R_r$ den Unterschied des Widerstandes zwischen der antiparallelen und der parallelen Magnetisierungsausrichtung der Meßschicht bezüglich der Biasschicht bzw. eines entsprechenden Biasschichtpaketes dar. In der vorstehend aufgeführten Gleichung ist die gegenseitige Ausrichtung der Magnetisierung der Meßschicht und der Biasschicht durch die Ausrichtung der Pfeile veranschaulicht. Im allgemeinen wird ein magnetoresistiver Effekt als GMR-Effekt bezeichnet, wenn die Größe $\Delta R_r$ mindestens 2 % (bei Raumtemperatur) beträgt. Vorteilhaft kann der schichtförmige Aufbau des Sensorelementteils $E_j$ mit großem magnetoresistiven Effekt auch als sogenanntes Multischichtensystem ausgeführt sein. Ein solches System zeichnet sich dadurch aus, daß es neben dem vorstehend erläuterten Schichtensystem noch weitere Schichten oder Schichtpakete enthält und gegebenenfalls eine Folge von periodisch wiederkehrenden Schichten besitzt (vgl. z.B. DE 42 43 358 A).

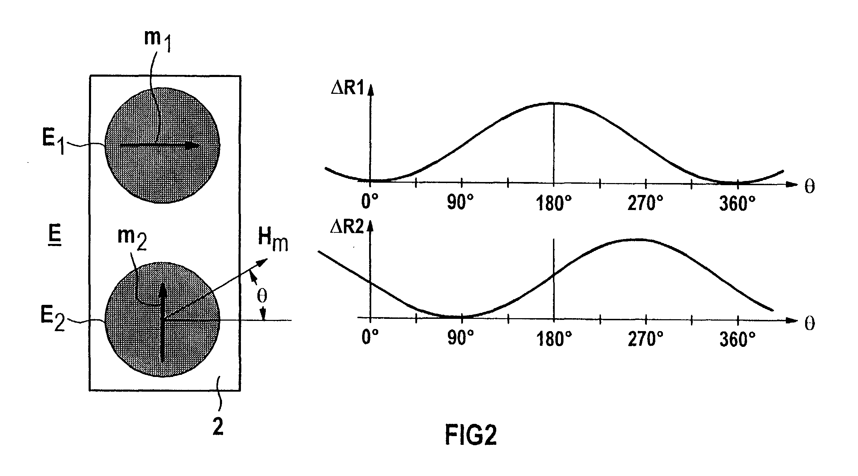

In Figur 2 sind zwei Sensorelementteile $E_1$ und $E_2$ mit jeweils kreisförmigem Querschnitt angedeutet. Gemeinsam bilden diese Sensorelementteile ein Sensorelement E einer erfindungsgemäßen Sensoreinrichtung. Eine solche Sensoreinrichtung kann dabei mehrere derartige Elemente aufweisen, die beispielsweise zu einer Brücke verschaltet sein können. Die Magnetisierungen der Biasschichten von jedem Elementteil sind einheitlich in der Ebene des gemeinsamen Substrates 2 gerichtet und mit $m_1$ bzw. $m_2$ bezeichnet. Diese Magnetisierungsrichtungen legen für jeden Sensorelementteil eine Bezugsrichtung fest, bezüglich derer ein Orientierungswinkel θ der in der Ebene der Meßschicht liegenden Komponente eines gerichteten äußeren Magnetfeldes $\mathbf{H}_m$ gemessen wird. Wie aus der Figur hervorgeht, sollen diese Bezugslinien bzw. die entsprechenden Biasschicht-Magnetisierungsrichtungen jedes zu einem Sensorelement gehörenden Elementteils $E_1$ und $E_2$ untereinander einen Winkel α einschließen, der erfindungsgemäß ungleich (≠) 0° oder ≠ 180° ist. Allgemein soll für diesen Winkel α zumindest annähernd gelten: $α = (n·45°)$ mit n = 1,2,3,5,6,7, wobei eine Abweichung um ± 10° mit eingeschlossen sein soll. Als besonders vorteilhaft ist ein dem Ausführungsbeispiel der Figur 2 zugrunde gelegter Winkel α von zumindest annähernd 90° anzusehen. Für diesen Fall werden von dem Orientierungswinkel θ abhängige Widerstandsänderungen ΔR1 bzw. ΔR2 erhalten, die aus den zugeordneten Diagrammen hervorgehen. Wie bei einer gemeinsamen Betrachtung dieser Diagramme sich sofort erkennen läßt, kann man vorteilhaft den Winkel θ ohne Auflösungseinbußen eindeutig im kompletten Winkelbereich zwischen 0 und 360° bestimmen. Hierzu dient eine in der Figur nicht dargestellte Meßsignal-Auswertevorrichtung. Diese Auswertevorrichtung wird mit jedem der Sensorelementteile $E_1$ und $E_2$ einzeln verbunden.

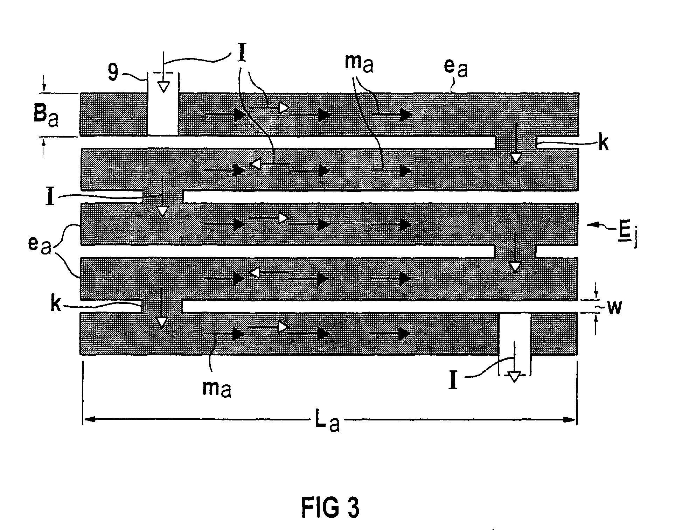

Figur 3 zeigt eine an sich bekannte Ausführungsform (vgl. DE 195 07 303 A) für einen Sensorelementteil $E_j$ eines Sensorelementes einer erfindungsgemäßen Sensoreinrichtung. Dieser Elementteil setzt sich aus mehreren, in Führungsrichtung eines Stromes I langgestreckten, streifenförmigen Teilstücken $e_a$ zusammen. Diese gemäß Figur 3 fünf Teilstücke haben jeweils eine vorbestimmte Länge $L_a$ und eine vorbestimmte Breite $B_a$ und sind parallel nebeneinander unter Ausbildung eines gegenseitigen Zwischenraums der Weite w angeordnet. Sie sind in Stromführungsrichtung gesehen mäanderförmig mittels Kontaktbrücken k hintereinandergeschaltet. Diese Kontaktbrücken sind dadurch realisiert, daß sowohl die Teilstücke $e_a$ als auch die Kontaktbrücken durch entsprechende Strukturierung, beispielsweise mittels Elektronenlithographie, aus einem gemeinsamen flächenhaften Schichtaufbau herausgearbeitet sind. In der Figur sind ferner unmagnetische Stromanschlußbahnen des Sensorelementteils $E_j$ mit 9 sowie die Magnetisierungs- bzw. Bezugsrichtungen der Biasschichten der einzelnen Teilstücke mit $m_a$ bezeichnet.

Die Vorteile der in Figur 3 angedeuteten Ausführungsform sind zum einen darin zu sehen, daß ein gewünschtes Impedanzniveau von einigen kΩ erreichbar ist. Zum anderen läßt sich durch eine vorbestimmte Geometrie und durch eine aufgeprägte Vorzugsrichtung in den Meßschichten ein isotropes Magnetisierungsverhalten einstellen. Ein weiterer Vorteil der gezeigten Geometrie ist, daß die Streifenform zu einer Stabilisierung der Magnetisierung in den Biasschichten beitragen kann.

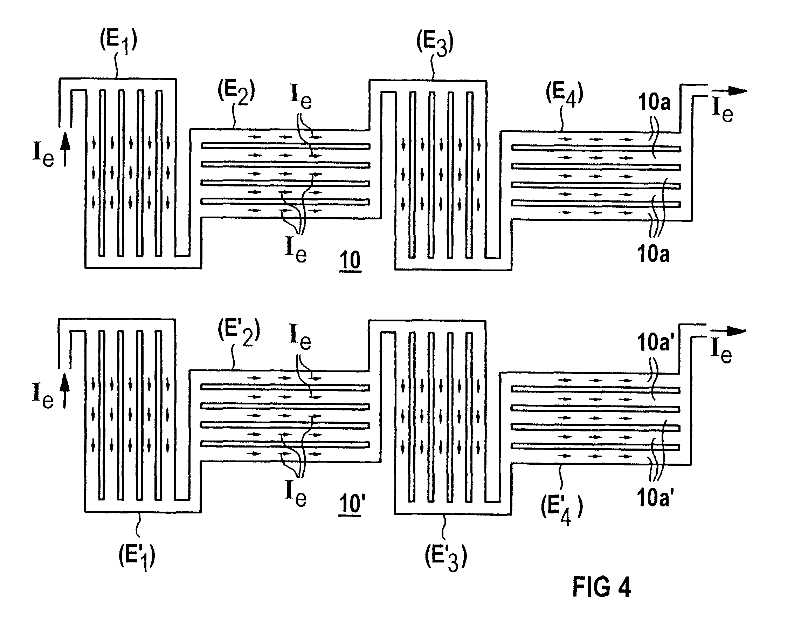

Bei den Sensorelementen einer erfindungsgemäßen Sensoreinrichtung müssen in den Biasschichten oder Bias-schichtpakete der einzelnen Sensorelementteile auf engem Raum Magnetisierungen mit verschiedener Ausrichtung eingeprägt werden. Vorteilhaft können hierzu Magnetisierungseinrichtungen vorgesehen werden, wie sie aus den DE-A-Schriften 195 20 172, 195 20 178 oder 195 20 206 hervorgehen. Bei diesen Magnetisierungseinrichtungen werden zur Einstellung der Magnetisierungen Magnetfelder von Strömen durch Streifenleiter ausgenutzt, die oberhalb der einzelnen Sensorelementteile verlaufend diesen zugeordnet sind. Dabei können die Streifenleiter entweder direkt und isoliert auf dem jeweiligen Mehrschichtsystem aufgebracht und mit diesem verbunden sein oder getrennt von diesem Mehrschichtsystem oberhalb diesem positioniert werden. Eine mögliche Ausführungsform entsprechender Streifenleiter ist in Figur 4 dargestellt. Dabei ist davon ausgegangen, daß zwei gleiche, sich parallel erstreckende Sensorelemente E und E' jeweils vier hintereinandergeschaltete Sensorelementteile $E_1$ bis $E_4$ bzw. $E'_1$ bis $E'_4$ besitzen. Jeder Sensorelementteil ist dabei entsprechend der Ausführungsform nach Figur 3 ausgebildet. Jeweils zwei hintereinandergeschaltete Sensorelementteile weisen senkrecht zueinanderstehende Magnetisierungsrichtungen gemäß Figur 2 auf. In der Figur sind nur Streifenleiteranordnungen 10 bzw. 10' ersichtlich, welche die Mehrschichtensysteme der einzelnen Sensorelementteile $E_1$ bis $E_4$ bzw. $E'_1$ bis $E'_4$ der Sensorelemente abdecken. Die Streifenleiteranordnungen 10 bzw. 10' weisen dabei im Bereich der einzelnen Sensorelementteile Streifenleiter 10a bzw. 10a' auf, die jeweils oberhalb eines zugeordneten Teilstücks ($e_a$) eines Sensorelementteils verlaufen. Im Bereich der Sensorelementteile sind die Streifenleiter 10a und 10a' parallelgeschaltet. Der über die Streifenleiteranordnungen zu führende Einstellstrom zur Erzeugung der jeweiligen magnetischen Einstellfelder ist mit $I_e$ bezeichnet.

Eine derartige Parallelschaltung einzelner, beispielsweise durch Schlitzung einer größeren Fläche gewonnener Streifenleiter kann vorteilhaft auch für andere, verhältnismäßig großflächige Sensorelementteile oder Sensorelemente vorgesehen werden. Dadurch läßt sich nämlich gewährleisten, daß bei abgeknickter Stromführungsrichtung ( vgl. Figur 4 ) der Strom in die Richtung der einzelnen Streifenleiter und nicht in eine dazu schräg verlaufende Richtung gezwungen wird. Die Magnetisierungsrichtung ist dann entsprechend exakt festzulegen.

## Patentansprüche

1. Sensoreinrichtung zur Erfassung der Richtung eines äußeren Magnetfeldes mittels wenigstens eines Sensorelementes, das 5 einen sehr großen magnetoresistiven Effekt (GMR) zeigendes Mehrschichtensystem aufweist, welches

   - mindestens eine weichmagnetische Meßschicht,
   - mindestens eine vergleichsweise härtere Biasschicht mit vorgegebener Magnetisierungsrichtung

   und

   - mindestens eine dazwischen angeordnete nicht-magnetische Zwischenschicht

   enthält, **dadurch gekennzeichnet, daß** das wenigstens eine Sensorelement (E, E') mindestens zwei Elementteile ($E_j$, $E_1$ bis $E_4$, $E_1'$ bis $E_4'$) enthält,

   - deren Mehrschichtensysteme (S) auf einem gemeinsamen Substrat (2) in dünnen Schichten aufgebracht sind,
   - wobei deren Magnetisierungsrichtungen ($m_1$ bis $m_4$) mit einem eingeschlossenen Winkel ($\alpha$) ungleich 0° oder ungleich 180° eingeprägt werden und
   - deren Meßsignale ($\Delta R1, \Delta R2$) gemeinsam auszuwerten sind.

2. Sensor einrichtung nach Anspruch 1, **dadurch gekennzeichnet, daß** jedes der Elementteile ($E_j$, $E_1$ bis $E_4$, $E_1'$ bis $E_4'$) einzeln mit einer gemeinsamen Signalauswertungsvorrichtung verbunden ist.

3. Sensoreinrichtung nach Anspruch 1 oder 2, **gekennzeichnet durch** einen von den Richtungen der Magnetisierungen ($m_1$ bis $m_4$) zweier Elementteile eines Sensorelementes eingeschlossenen Winkel ($\alpha$) zwischen 20° und 160° oder zwischen 200° und 340°.

4. Sensoreinrichtung nach Anspruch 3, **gekennzeichnet durch** einen von den Richtungen der Magnetisierungen ($m_1$ bis $m_4$) eingeschlossenen Winkel ($\alpha$) von zumindest annähernd ($n \cdot 45°$) $\pm$ 10° mit n = 1, 2, 3, 5, 6 oder 7.

5. Sensoreinrichtung nach Anspruch 4, **gekennzeichnet durch** einen von den Magnetisierungsrichtungen ($m_1$, $m_2$) eingeschlossenen Winkel ($\alpha$) von zumindest annähernd 90° oder 270°.

6. Sensoreinrichtung nach einem der Ansprüche 1 bis 5, **gekennzeichnet durch** Elementteile ($E_j$) mit gleichem Schichtaufbau und gleicher Geometrie.

7. Sensoreinrichtung nach einem der Ansprüche 1 bis 6, **dadurch gekennzeichnet, daß** die Meßschichten (7) und/oder die Biasschichten jedes Elementteiles ($E_j$) aus einem Schichtpaket aus mehreren Schichten gebildet sind.

8. Sensoreinrichtung nach einem der Ansprüche 1 bis 7, **dadurch gekennzeichnet, daß** jedem Mehrschichtensystem (S) eines Elementteiles ($E_j$) wenigstens eine Leiterbahn (10a) zur Führung eines Einstellstromes ($I_e$) zur festen Einstellung der Magnetisierung in der mindestens einen Biasschicht des Mehrschichtensystems zugeordnet ist.

9. Sensoreinrichtung nach Anspruch 8, **dadurch gekennzeichnet, daß** mehrere elektrisch parallelgeschaltete Leiterbahnen (10a) eine Streifenleiteranordnung (10, 10') bilden.

## Claims

1. Sensor device for detecting the direction of an external magnetic field by means of at least one sensor element which has a multilayer system which shows a very great magnetoresistive effect (GMR) and which includes

   - at least one soft magnetic measurement layer,

   - at least one relatively harder bias layer having a predetermined direction of magnetization

   and

- at least one nonmagnetic intermediate layer disposed therebetween, **characterized in that** the at least one sensor element (E, E') includes at least two element parts ($E_j$, $E_1$ to $E_4$, $E_1'$ to $E_4'$),

- the multilayer systems (S) of which are applied in thin films to a common substrate (2),

- the magnetization directions ($m_1$ to $m_4$) of which thin films being subject to an angle ($\alpha$) unequal to 0° or unequal to 180°

and

- the measurement signals ($\Delta R1$, $\Delta R2$) of which are to be evaluated in common.

2. Sensor device according to Claim 1, **characterized in that** each of the element parts ($E_j$, $E_1$ to $E_4$, $E_1'$ to $E_4'$) is connected individually to a common signal evaluating device.

3. Sensor device according to Claim 1 or 2, **characterized by** an angle ($\alpha$) included by the directions of the magnetizations ($m_1$ to $m_4$) of two element parts of a sensor element of between 20° and 160° or between 200° and 340°.

4. Sensor device according to Claim 3, **characterized by** an angle ($\alpha$) included by the directions of the magnetizations ($m_1$ to $m_4$) of at least approximately $(n \cdot 45°) \pm 10°$ where n = 1,2,3,5,6 or 7.

5. Sensor device according to Claim 4, **characterized by** an angle ($\alpha$) included by the magnetization directions ($m_1$, $m_2$) of at least approximately 90° or 270°.

6. Sensor device according to one of Claims 1 to 5, **characterized by** element parts ($E_j$) having the same layer structure and the same geometry.

7. Sensor device according to one of Claims 1 to 6, **characterized in that** the measurement layers (7) and/or the bias layers of each element part ($E_j$) are formed from a layer packet comprising a plurality of layers.

8. Sensor device according to one of Claims 1 to 7, **characterized in that** at least one conductor track (10a) for conducting a setting current ($I_e$) for the fixed setting of the magnetization in the at least one bias layer of the multilayer system is associated with each multilayer system (S) of an element part ($E_j$).

9. Sensor device according to Claim 8, **characterized**

**in that** a plurality of conductor tracks (10a) electrically connected in parallel form a strip conductor arrangement (10, 10').

## Revendications

1. Dispositif formant capteur destiné à détecter la direction d'un champ magnétique extérieur au moyen d'au moins un élément formant capteur, qui comporte un système multicouche ayant un effet magnéto-résistif très grand (GMR), lequel système multicouche comporte

- au moins une couche de mesure à magnétisme doux,
- au moins une couche de polarisation relativement plus dure à sens de magnétisation prédéterminé et

au moins une couche intermédiaire amagnétique disposée entre les deux couches précédentes,
**caractérisé en ce que** l'au moins un élément formant capteur (E, E4) comporte au moins deux parties d'élément ($E_1$, $E_2$ à $E_4$, $E_1'$ à $E_4'$),

- dont les systèmes multicouches (S) sont déposés en couches minces sur un substrat commun,
- leur direction de magnétisation ($m_1$ à $m_4$) faisant un angle ($\alpha$) différent de 0° ou différent de 180° et
- leurs signaux de mesure ($\Delta R1$, $\Delta R2$) peuvent être exploités conjointement.

2. Dispositif formant capteur selon la revendication 1, **caractérisé en ce que** chacune des parties d'élément ($E_j$, $E_1$ à $E_4$, $E_1'$ à $E_4'$) est relie individuellement à un dispositif d'exploitation de signaux commun.

3. Dispositif formant capteur selon la revendication 1 ou 2, **caractérisé en ce que** l'angle entre les directions de magnétisation ($m_1$ à $m_4$) des deux parties d'élément d'un élément formant capteur est compris entre 20° et 160° ou entre 200° et 340°.

4. Dispositif formant capteur selon la revendication 3, **caractérisé en ce que** l'angle ($\alpha$) entre les directions de magnétisation ($m_1$ à $m_4$) est égal au moins approximativement à $(n \times 45°) \pm 10°$ avec n = 1, 2, 3, 5, 6 ou 7.

5. Dispositif formant capteur selon la revendication 4, **caractérisé en ce que** l'angle ($\alpha$) entre les directions de magnétisation ($m_1$ à $m_4$) est égal au moins approximativement à 90° ou 270°.

**6.** Dispositif formant capteur selon l'une des revendications 1 à 5, **caractérisé par** des parties d'élément ($E_j$) présentant une même structure en couche ou une même géométrie.

**7.** Dispositif formant capteur selon l'une des revendications 1 à 6, **caractérisé en ce que** les couches de mesure (7) et/ou les couches de polarisation de chaque partie d'élément ($E_j$) sont formées à partir d'un paquet de plusieurs couches.

**8.** Dispositif formant capteur selon l'une des revendications 1 à 7, **caractérisé en ce que** au moins une piste conductrice (10a), destinée à conduire un courant de réglage ($I_e$) pour régler de façon fixe la magnétisation dans l'au moins une couche de polarisation du système multicouche, est associée à chaque système multicouche (S) d'une partie d'élément ($E_j$).

**9.** Dispositif à capteur selon la revendication 8, **caractérisé en ce que** plusieurs pistes conductrices (10a), montées électriquement en parallèle, forment un agencement de conducteurs à ruban (10, 10').

FIG 1

FIG2

FIG 3

FIG 4

EP 0 905 523 B1